# EUROPÄISCHE PATENTANMELDUNG

(11) **EP 1 458 019 A2**
(43) Veröffentlichungstag der Anmeldung: **15.09.2004**
(21) Anmeldenummer: 04005376.1
(22) Anmeldetag: 06.03.2004
(51) Int. Cl.: H01L 21/68, H01L 21/00

(54) **Mobiler transportabler elektrostatischer Substrathalter**

(30) Priorität: 13.03.2003 DE 20304124 U; 29.07.2003 DE 20311625 U
(71) Anmelder: VenTec Gesellschaft für Venturekapital und Unternehmensberatung, 57078 Siegen (DE)
(72) Erfinder: Busse, Karl-Hermann, Prof. Dr., 57234 Wilnsdorf (DE); Keilbach, Steffen, 65468 Trebur (DE)
(74) Vertreter: Pürckhauer, Rolf, Dipl.-Ing.

(57) **Zusammenfassung**

Es werden verschiedene Ausführungen von sogenannten mobilen transportablen Substrathaltern (Transfer-ESC's) für unterschiedliche Einsatzbereiche insbesondere für die Handhabung von Wafern in der Halbleiterindustrie beschrieben.
Hierdurch wird vor allem eine gute Anpassung an die bereits vorhandenen Fertigungsabläufe erreicht und auch die Gefahr von Ausbeuteverlusten bei der Herstellung der Bauelemente drastisch reduziert.

## Beschreibung

### Stand der Technik

Stationäre elektrostatische Halter werden seit Jahren bei der Handhabung von scheibenartigen leitenden und halbleitenden Werkstoffen, im Besonderen zur Handhabung als Haltevorrichtung für sogenannte Wafer in Produktionsanlagen der Halbleiterindustrie verwendet. Das Wirkprinzip ist eingehend in Veröffentlichungen beschrieben wie: Shermann et. al.: Semiconductor International V 20 Jul. 1997, 319-21; Olson et. al.: Rev. Sci. lnstrum. 66 (2) Feb. 1995, 1108-14; Watanabe et. al.: Jpn. J. Appl. Phys. Vol (32) 1993, 864-71; Hartsough: Solid State Technology, Jan. 1993, 87-90.

Die Verfahren zur Umsetzung dieser Prinzipien auf sogenannte mobile transportable elektrostatische Haltesysteme sind eingehend in EP 1 217 655 A1, US 2002/0110449 A1 sowie WO / 02 11184 A1 beschrieben und repräsentieren den Stand der Technik.

Die praktische Umsetzung der Verfahren zur mobilen elektrostatischen Handhabung führte zur Entwicklung erster mobiler elektrostatischer Haltevorrichtungen (sog. Tansfer-ESC's, abgekürzt T-ESC's) zum elektrostatischen Halten von folienartigen Werkstücken (z. B. Siliziumwafern) insbesondere für die Halbleitertechnik, vgl. EP 1 217 655 A1.

### Beschreibung der Erfindungen

Die ersten vorgeschlagenen Lösungen erfüllen jedoch viele technische und wirtschaftliche Anforderungen an derartige mobile, elektrostatische Halter (Substrathalter) nur unbefriedigend.

Dieser Sachverhalt liegt daran, dass die transportablen elektrostatischen Substrathalter nur im geringen Maß den unterschiedlichen Einsatzbereichen und Prozeßschritten bei dem Bearbeiten sowie dem Handhaben von Wafern vor allem im Bereich der Halbleiterindustrie angepasst sind. Der gleiche Umstand gilt jedoch auch für andere wichtige Industriebereiche, z. B. der Solar-, Medizin- und Audiotechnik beim Handhaben dünner Substrate, u. a. von Solarzellen, Filtern, Speichermedien. Hier existieren viele analoge Problemstellungen wie in der Halbleitertechnik.

Daher werden im Nachfolgenden verschiedene Ausführungen von mobilen transportablen elektrostatischen Substrathaltern (T-ESC's), insbesondere für den Bereich der Halbleiterindustrie vorgeschlagen, die vielfach auch unverändert in anderen Industriezweigen eingesetzt werden können.

Hierdurch wird in der Halbleiterindustrie vor allem die Gefahr von Ausbeuteverlusten, z. B. durch den Bruch bzw. die mechanische Zerstörung der Bauelemente, drastisch reduziert.

Neben der Dicke der mobilen elektrostatischen Substrathalter (vgl. hierzu EP 1 217 655 A1) ist ein weiteres wichtiges Maß deren Durchmesser. In der Regel bietet es sich in der Halbleitertechnik an, um das Kantenbruchrisiko der relativ spröden Wafer, z. B. aus Silizium bzw. anderen Halbleiterwerkstoffen, wie z. B. Galliumarsenid zu minimieren, den Durchmesser der Substrathalter gleich groß, wie die standardisierten Wafer (vgl. Semi-Standard, z. B. M1.9-0699) und weitgehend deckungsgleich zu den vorhandenen Wafergeometrien, z. B. rund oder mit Abkantung (sogenannte Flats, vgl. die einschlägigen Semi-Standards) auszulegen.

Für einige Prozesse, wie dem Plasmaätzen, ist es jedoch sinnvoll den Durchmesser (kreisförmiges, rundes Substrat, ggf. mit sogn. Flat) bzw. die äußeren Abmessungen (z. B. die Kantenlänge bei mehreckigen Substraten) des mobilen elektrostatischen Halters im Vergleich zum Wafer um 0,1 bis zu 30 mm zu verringern. Hierdurch kommt es einerseits bei geringen Ätzabträgen zu Kantenrundungen, welche die Bruchgefahr der Wafer drastisch zu reduzieren vermögen und andererseits wird durch einen signifikant verkleinerten mobilen elektrostatischen Substrathalter im Vergleich zum transportierten Wafer die Gefahr von elektrischen Durchschlägen auf den mobilen elektrostatischen Halter verringert und auch eine schnelle Erosion des Transfer-ESC's im Plasma verhindert.

Wenn zum Halten des mobilen elektrostatischen Halters eine weitere fest eingebaute stationäre elektrostatische Haltevorrichtung verwendet wird, bietet es sich an, um die Haftung des mobilen elektrostatischen Halters zu erhöhen, die dem stationären elektrostatischen Halter zugewandte Seite mit Metallen (z. B. Aluminium, Nickel) und / oder Halbmetallen (z. B. Silizium) und / oder Metalllegierungen (z. B. Nickelchromlegierungen) örtlich, stellenweise oder komplett zu beschichten. Hieran kann falls nötig ein zusätzliches elektrisches Potential angelegt werden. So können unipolare und / oder mehrpolare Rückseitenelektroden entstehen.

Eine weitere Möglichkeit besteht darin, magnetische Werkstoffe (z. B. Ferrite) massiv in den mobilen elektrostatischen Substrathalter einzuarbeiten oder diesen örtlich, stellenweise oder komplett mit derartigen Werkstoffen zu beschichten. Dieser kann dann magnetisch mittels einer entsprechend mit Magneten ausgestatteten Aufnahme(vorrichtung) gehalten werden.

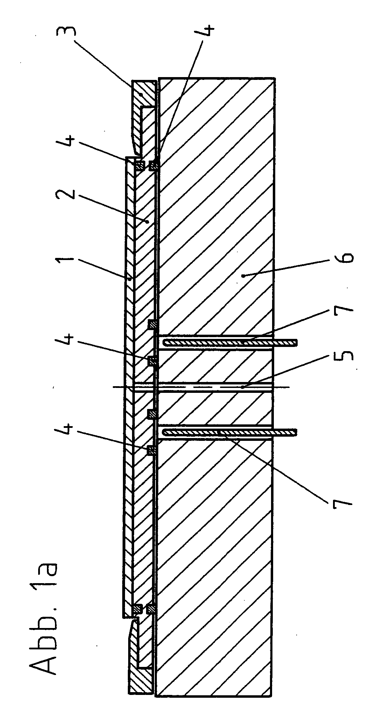

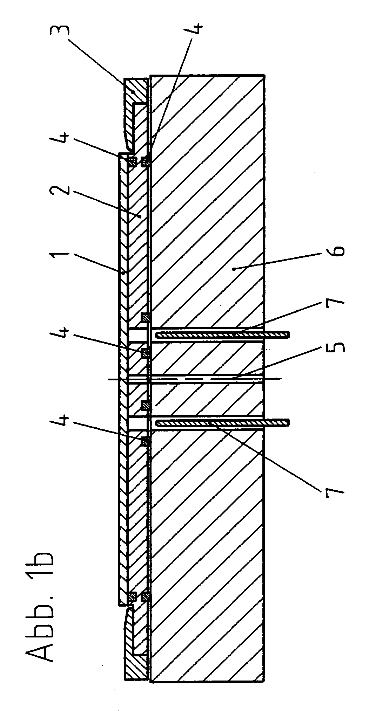

In anderen Fällen, wo es erforderlich ist den mit dem Substrat (z. B. Wafer) beaufschlagten mobilen elektrostatischen Halter mechanisch, z. B. durch einen Greifer oder eine Klemmvorrichtung zu handhaben oder / und zu fixieren bietet es sich an, örtlich, stellenweise oder über alle äußeren Geometrien den mobilen elektrostatischen Substrathalter größer als das zu transportierende Substrat (z. B. Wafer) auszulegen. Bezogen auf den Durchmesser oder die äußeren Abmessungen des Substrats (z. B. Wafer mit 300 mm Durchmesser) kann der mobile elektrostatische Halter bis zu 150 mm größer sein. Der überstehende Rand von bis zu 150 mm kann dann zum Klemmen bzw. zum mechanischen Handhaben des mit dem Substrat (z. B. Wafer) beaufschlagten transportablen elektrostatischen Halters genutzt werden. Durch einen zusätzlichen örtlich, stellenweise oder umlaufend den Rand überdeckenden, z. B. aus einem aus Kunststoff, wie Polyimid oder einer Keramik, wie Aluminiumoxid, bestehenden Klemm- und Schutzring kann der überstehende Rand des mobilen elektrostatischen Halters vor einem Plasmaangriff wirksam geschützt werden (Abbildung 1a, 1b).

Weiterhin ermöglicht das mechanische Klemmen der mobilen elektrostatischen Halter im Vergleich zu stationären, fest in die Behandlungsmaschine eingebauten elektrostatischen Haltern eine signifikante Effizienzsteigerung (Produktivitätssteigerung) der Fertigungsmaschinen. So sind zum gegenwärtigem Zeitpunkt in der Halbleiterindustrie viele Fertigungsmaschinen, beispielsweise zum Plasmaätzen, in der Regel mit fest eingebauten stationären elektrostatischen Haltesystemen ausgestattet.

Das elektrische (elektrostatische) Laden und Entladen des elektrostatischen Haltesystems zum Anziehen (Laden) und Loslassen (Entladen) des Substrates (Wafer) kann dabei je nach verwendeten Werkstoffen für das Dielektrikum des elektrostatischen Halters (ggf. unterstützt durch sogn. Memory-Effekte), Größe und Abmessungen der Wafer bis zu rd. 20 Sekunden bei stationären elektrostatischen Haltevorrichtungen nach dem Stand der Technik pro Prozesskammer dauern. Wird jedoch der zeitintensive Lade- und Entladevorgang durch das Verwenden eines hier beschriebenen mobilen elektrostatischen Halters außerhalb der Fertigungsmaschine (z. B. Plasmaanlage) vorgenommen und der mobile mit einem Wafer beaufschlagte Halter in die Maschine eingeschleust und innerhalb dieser durch Klemmen mechanisch gehalten und fixiert, kann der Durchsatz der äußerst teuren Behandlungsmaschinen um ca. 5-25% (je nach Prozesszeit) gesteigert werden. So können die Klemmringe bzw. -vorrichtungen in der seit langer Zeit bekannten Weise, z. B. mittels Elektromotoren, pneumatischen Vorschub sehr schnell auf und zu gefahren werden. Diese mechanischen Klemmvorrichtungen wurden bereits als stationäre elektrostatische Halter noch nicht bekannt bzw. verbreitet waren, eingesetzt. Jedoch klemmten diese das Substrat (z. B. den Wafer) und nicht, wie hier beschrieben, den mobilen elektrostatischen Halter.

Da die zu behandelnden Wafer gemäß dieser Erfindung nicht von den Klemmringen überdeckt werden, entspricht die Größe der bearbeitbaren Waferoberfläche der beim Verwenden von stationären elektrostatischen Haltern, d. h. es gibt keine Ausbeuteverluste infolge des Überdeckens der Waferoberfläche durch den Klemmring, wie bei alten Klemmvorrichtungen. Auch steigt hierdurch nicht die Partikelgenerartion, wie bei rein mechanischen Klemmsystemen alter Bauart. So wurden unerwünschte Partikel vor allem an der Schnitt- bzw. Kontaktstelle Wafer /Klemmring durch das Öffnen und / oder Schließen der Klemmringe und z. B. infolge des Zerreißens von Kontaminationsschichten, z. B. bestehend aus Plasmapolymeren, generiert.

Gleichzeitig verringert sich durch den Einsatz von mobilen elektrostatischen Haltern, gemäß der Erfindung, der Verbrauch an Betriebsstoffen (Gase ect.) pro prozessiertem Substrat (Wafer) erheblich. Da die mobilen elektrostatischen Halter ähnlich hohe Standzeiten, wie die teuren, fertigungstechnisch aufwendigen stationären elektrostatischen Halter erreichen können, jedoch wesentlich günstiger zu produzieren sind, sinken zudem signifikant die Instandhaltungskosten.

Der über den Abmessungen des Substrats (z. B. Wafer) hinausgehende Rand des mobilen elektrostatischen Halters kann örtlich, stellenweise oder umlaufend, um bis zu 30 mm dicker und bis zu 10 mm dünner, als der durch das Substrat abgedeckte Bereich sein. Dieses Auslegungsmerkmal ermöglicht es beispielsweise bei erhöhter Dicke, wie in EP 1 217 655 A1 beschrieben, Akkumulatoren, Batterien und aufwendige Elektronik größerer Abmessungen in den mobilen elektrostatischen Haltern unterzubringen. Andererseits vereinfacht ein dünner Rand das mechanische Klemmen und Zentrieren des mobilen elektrostatischen Haltesystems innerhalb der Fertigungsmaschine.

Natürlich können z. B. die Akkumulatoren, die Elektronik, wie in EP 1 217 655 A1 ausgeführt, auch in örtlich ständig oder nicht ständig vorhandenen Gehäusen verschiedener Bauart untergebracht sein. Beispielsweise kann so ein flexibles, stetiges oder nicht stetiges automatisches oder manuelles Handhaben, elektrisches Nachladen und Entladen der mobilen elektrostatischen Halter in sogenannten Wafer-Carriern ermöglicht werden.

Sehr hohe Scherkräfte treten im Bereich der Halbleiterindustrie insbesondere beim Schleifen und beim Polieren der Wafer auf.

Die elektrostatische Haltekraft ist bei hohen Abtragsraten oftmals nicht mehr ausreichend, um den Wafer sicher bei den vorgenannten mechanischen Bearbeitungsvorgängen zu fixieren.

ln den meisten Fällen werden daher zum gegenwärtigem Zeitpunkt in Schleif- und Poliermaschinen und vielfach auch in anderen atmosphärischen Behandlungseinrichtungen zum Fixieren und Halten der Wafer sogenannte Vakuumhalter (Vakuumaufnahmen) eingesetzt. Hierbei wird durch eine Vakuumpumpe auf der Rückseite der Wafer ein Vakuum erzeugt. Entsprechend der jeweiligen Druckdifferenz kann die Haltekraft bis zu rd. 0,1 N / mm² betragen.

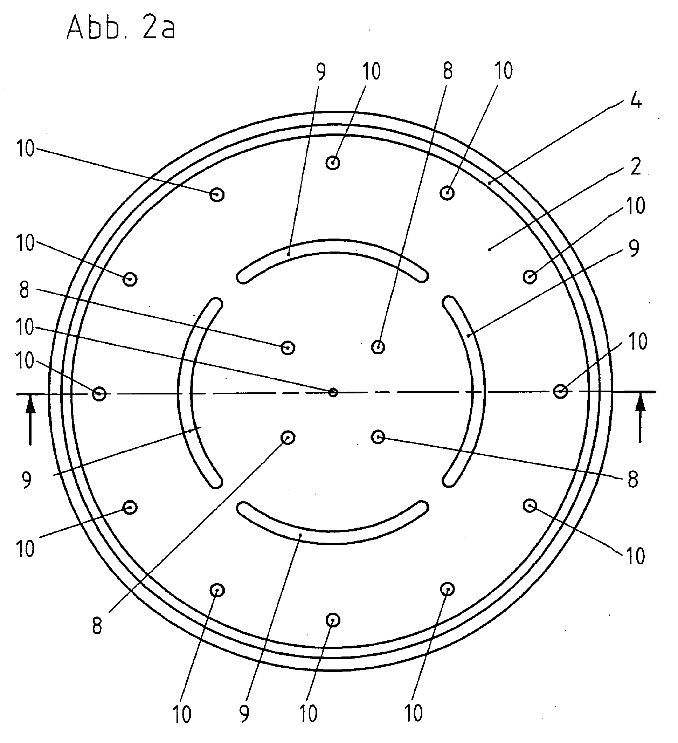

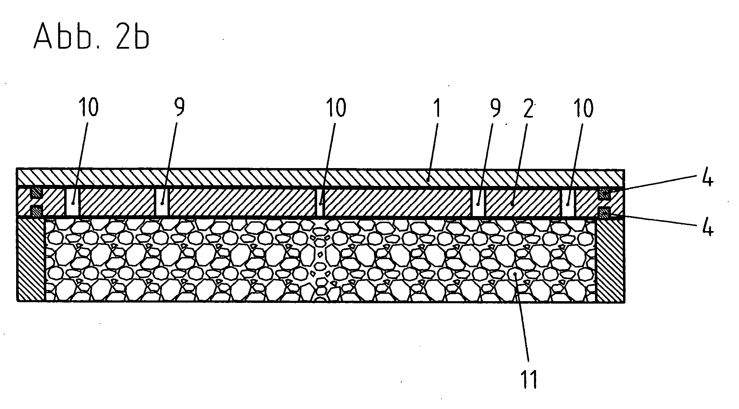

Vielfach bestehen, um eine gleichmäßige Druckverteilung (Haltekraftverteilung) zu erzielen, die Vakuumhalter (Vakuumaufnahmen, Waferaufnahmen) aus (homogenen) porösen Werkstoffen oder aus gelochten und auch ringförmig perforierten Scheiben (Abbildung 2a, 2b).

Wird jedoch der mobile elektrostatische Halter in vergleichbarer Weise, wie der in der jeweiligen Schleif-, Polier- oder atmosphärischen Behandlungsmaschine (z. B. auch in einem Spinätzer oder diversen Lithographieeinrichtungen) vorhandene Vakuumhalter (Vakuumaufnahme) perforiert (Abbildung 2a, 2b), kann neben der elektrostatischen Haltekraft zusätzlich ein wesentlicher Teil der durch den Vakuumhalter (aufgrund der Druckdifferenz) erzeugten Haltekraft zum Fixieren des Wafers auf dem elektrostatischen Halter genutzt werden.

Um eine gleichmäßige Wirkung des Vakuums zum Festhalten der Wafer zu erreichen und das Eindringen von Flüssigkeiten, z.B. Schleifemulsionen, Säuren zum Spinätzen, zu verhindern, bietet es sich an die mobilen elektrostatischen Halter an der dem Wafer zugewandten und / oder abgewandten Seite (vgl. Abbildung 2a, 2b) mit Dichtungen (Dichtflächen) zu versehen. Diese können z. B. aus Polymeren, wie Silikone, Fluorkunststoffe und / oder auf der Basis von geeigneten Metallen, z. B. galvanisch abgeschiedenes Nickel und / oder Metalllegierungen (vor allem für höhere Temperaturen) bestehen.

Diese Dichtungen werden meist im äußeren Bereich (Abbildung 1 a, 1b) des mobilen elektrostatischen Halters ausgeführt. ln ähnlicher Weise können zusätzliche Dichtungen aus Polymeren und / oder Metallen und /oder Metallegierungen auch in den äußeren Bereich der Vakuumaufnahme eingebracht werden, um den Zwischenraum zwischen der Rückseite des mobilen elektrostatischen Halters und der Vakuumaufnahme abzudichten (nicht dargestellt in (Abbildung 2a, 2b)).

Mobile elektrostatische Halter vor allem zum Schleifen, Polieren, für die Photolithographie und zum naßchemischen Reinigen von Substraten (Wafern) sollten vorzugsweise aus Gläsern, Glaskeramiken, keramischen Werkstoffen oder Halbleiterwerkstoffen bestehen. So weisen diese einerseits ähnliche mechanische und physikalische Eigenschaften, wie die in der Halbleiterindustrie prozessierten Materialien (z. B. Silizium) auf und lassen sich beispielsweise leicht in einer Schleifmaschine zum Waferschleifen (vorab) hinsichtlich der erforderlichen Ebenheit bzw. Planparallelität kalibrieren. Andererseits sind diese meist hervorragende lsolatoren oder lassen sich entsprechend leicht modifizieren, so daß die Verlustströme auch in nassen Medien klein sind.

Vor allem die sogenannte Keramik- bzw. Glas- Multilayertechnik und der Einsatz von (foto-)strukturierbaren Gläsern, u. a. bekannt als Foturan® , hat sich bei der Herstellung von elektrostatischen Haltern, u. a. zum Schleifen und Polieren, als sehr hilfreich erwiesen. Auch können durch das Verwenden von Gläsern durchsichtige mobile elektrostatische Halter, welche sich beispielsweise für eine optische Justage von Schutzvorrichtungen (Verpackungen), z. B. für mikromechanische Bauteile (sogn. MEMS) eignen, hergestellt werden.

Ferner empfiehlt sich die Multilayertechnik von Kunststoffen, wie beim Herstellen von gedruckten Schaltungen, beispielsweise durch das Verwenden von chemisch sehr beständigen Polyimidfolien zum Herstellen von mobilen elektrostatischen Haltern zum Plasmaätzen, Spinätzen und für Transportaufgaben.

In vergleichbarer Weise, wie oben beschrieben, können mobile elektrostatische Halter auch für das Plasmaätzen, plasmaunterstütztes Abscheiden aus der Gasphase (PECVD), plasmaunterstütztes physikalisches Abscheiden (PVD) mit Perforierungen, Dichtungen, Dichtelementen und Strukturierungen der jeweiligen Oberflächen versehen werden.

So wird in der EP 1 217 655 A1 beschrieben, dass ein mobiler elektrostatischer Halter dazu verwendet werden kann, das Werkstück während der Bearbeitung, beispielsweise durch Plasmaätzen, zu fixieren. Bei den bisher bekannten Ausführungen ist jedoch nicht vorgesehen, eine dabei oftmals auftretende für das Werkstück bzw. den Wafer schädliche Erwärmung durch eine Kühlvorrichtung zu verhindern.

Daher sind in einer weiteren erfindungsmäßigen Ausführung eines mobilen elektrostatischen Halters im Substrathalter Bohrungen bzw. Perforationen enthalten, durch die während einer Bearbeitung des Wafers auftretende Erwärmungen durch eine Gaskühlung, beispielsweise mittels Helium, verringert werden können. In diesem Fall wird der Gasfluss durch die Bohrungen (Anmerkung: Sowohl im obigen Text als auch im nachfolgenden Text sind unter der Bezeichnung Bohrungen stets nicht nur runde sondern auch Durchbrüche und Perforationen anderer Geometrie, wie eckig, oval ect. zu verstehen.) so gegen den Wafer geführt, dass ein gasgefüllter Zwischenraum zwischen dem vorgenannten Werkstück und dem mobilen elektrostatischen Halter entsteht.

Eine besonders sichere Kühlwirkung wird dann erreicht, wenn das Kühlgas beispielsweise von einer oder von mehreren meist mittigen Bohrungen im elektrostatischen Halter durch Kühlgaskanäle in der der Waferrückseite zugewandten Oberfläche des mobilen elektrostatischen Halters verteilt wird. Diese der Waferrückseite zugewandten Kühlgaskanäle können, wie in EP 0 948 042 A1 und in US 6 215 641 B1 beschrieben, ausgeführt werden.

Die Bohrungen bzw. Perforationen des mobilen elektrostatischen Halters sind neben der Nutzung für ein nötiges Kühlgas auch erforderlich, um Abhebestifte, Sensoren und Kontaktstifte an den Wafer heranzuführen.

Die Abhebestifte dienen zum Abheben und Absetzen des mit dem Substrat (Wafer) beladenen mobilen elektrostatischen Halters von und /oder auf die stationäre Aufnahme(-vorrichtung) oder wenn diese oder zusätzliche Abhebestifte durch Perforationen bzw. Bohrungen durch den mobilen elektrostatischen Halter geführt werden, auch zum Abheben und

Absetzen des Wafers auf dem auf der Aufnahme(-vorrichtung) fixierten (mobilen) elektrostatischen Halter (Abbildung 1a, 1b). Das Abheben geschieht, um den mit dem Substrat (Wafer) beaufschlagten elektrostatischen Halter oder nur das Substrat (Wafer) mittels eines Roboterarmes erfassen und transportieren zu können. In der gleichen o. a. Weise ist es möglich Sensoren, z. B. Temperaturfühler an die Rückseite des Substrates (Wafer) bzw. des mobilen elektrostatischen Halters heranzuführen. Ferner können Kontaktstifte an die Rückseite des mobilen elektrostatischen Halters geführt werden, um diesen falls nötig in der jeweiligen Fertigungsmaschine elektrisch nachzuladen. Das Nachladen in der Fertigungsmaschine ist vor allem dann nötig, wenn, wie es sich gezeigt hat, lange Prozesszeiten oder sehr hohe Temperaturen (> rd. 150 °C), die das in der Fertigungsmaschine unerwünschte elektrische Entladen des mobilen elektrostatischen Halters stark begünstigen können, vorliegen.

Falls der mobile elektrostatische Halter auf Halbleiterbasis ausgeführt ist und der sogenannte Johnson-Rahbek-Effekt (bzw. -Anordnung) genutzt wird, sind die Verlustströme meist so hoch, dass ein elektrisches Nachladen, wie o. a. in der Fertigungsmaschine vorgenommen werden muß. Hierdurch läßt sich oftmals nur die gewünschte Funktion sicherstellen.

Dadurch das in der Fertigungsmaschine bzw. Fertigungsumgebung elektrisch nachgeladen werden kann, entsteht aus dem mobilen elektrostatischen Substrathalter und der jeweiligen stationären Aufnahme(-vorrichtung) ein zusammengesetztes elektrostatisches Haltesystem, welches falls nötig so lange und in vergleichbarer Weise, wie ein konventionelles aus einem oder mehreren stationären Teilen bestehendes, fest eingebautes elektrostatisches Haltesystem betrieben werden kann.

Ein derartiges erfindungsgemäßes zwei- bzw. mehrteiliges Haltesystem hat gegenüber älteren, konventionellen Ausführungen den Vorteil, daß im Rahmen der Instandhaltung, z. B. in Vakuumanlagen zum Plasmaätzen, die Instandhaltung automatisch durch den Wechsel des meist als erstes Teil verschleißenden (mobilen) elektrostatischen Substrathalters mittels für die Wafer vorhandener Handhabungsroboter erfolgen kann, ohne die Vakuumkammern öffnen und diese mit der umgebenden Atmosphäre fluten zu müssen. Hierzu sind die mobilen elektrostatischen Halter hinsichtlich der Geometrie und den Abmessungen ähnlich der verwendeten Wafer auszulegen, damit spezielle Anpassungen der Maschinensysteme nicht nötig sind (vgl. auch EP 1 217 655 A1).

Bei konventionellen Systemen bisheriger Bauart benötigt die Instandhaltung zum Ein- und Ausbau der stationären elektrostatischen Haltesysteme und dem Einstellen eines stabilen Betriebszustandes (insbesondere eines stabilen Vakuums) in der Regel mehrere Stunden. Zudem lassen sich, wie bereits erwähnt, mobile elektrostatische Haltesysteme wesentlich kostengünstiger als die bekannten stationären elektrostatischen Haltesysteme herstellen.

Die Kontaktstifte können auch, wenn diese (infolge von Bohrungen, Perforationen durch den mobilen elektrostatischen Halter) an der Waferrückseite anliegen, zur elektrischen Entladung der Wafer bzw. Substrate verwendet werden (Abbildung 1b). Die vorgenannten Stifte können nur einzelne, alle oder mehrere der vorgenannten Funktionen aufweisen und beispielsweise sowohl als Abhebestifte, Kontaktstifte und Träger von Sensoren verwendet werden.

Die Durchführungen durch den mobilen elektrostatischen Halter sind meist, um einen erhöhten Abfluss des Kühlgases in den Prozessraum zu verhindern, mit weiteren Dichtungen umgeben (Abbildung 1b).

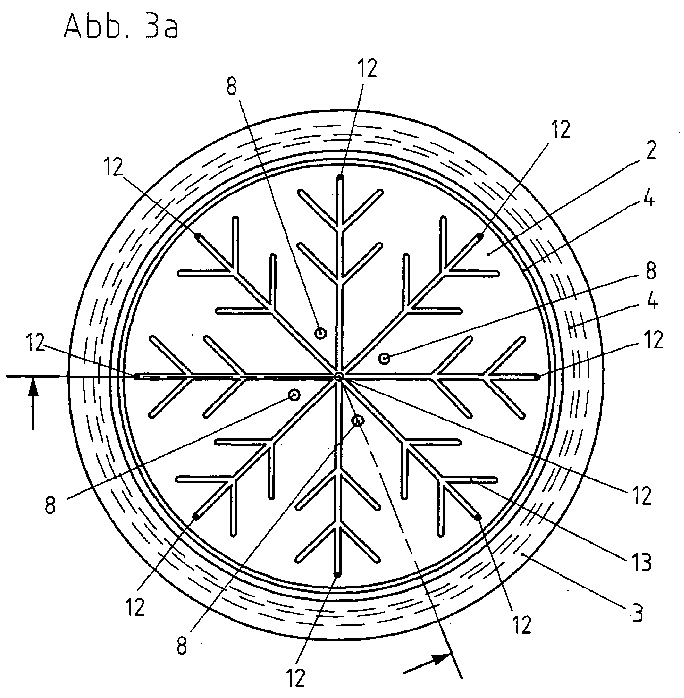

Bei einer bevorzugten Ausführung verfügt der mobile elektrostatische Halter, beispielsweise um die Kühlwirkung auf dem Wafer zu verbessern, über zusätzliche Dichtungen aus Polymeren, z.B. Silikone, Fluorkunststoffe (z. B. Fluorelastomere) und / oder Metallen (z. B. Nickel) und / oder Metalllegierungen (z. B. aus Nickelchromlegierungen). Diese Dichtungen können auf der dem Wafer zugewandten und / oder dem Wafer abgewandten Seite auf dem mobilen elektrostatischen Halter angebracht werden (Abbildung 3a-3c).

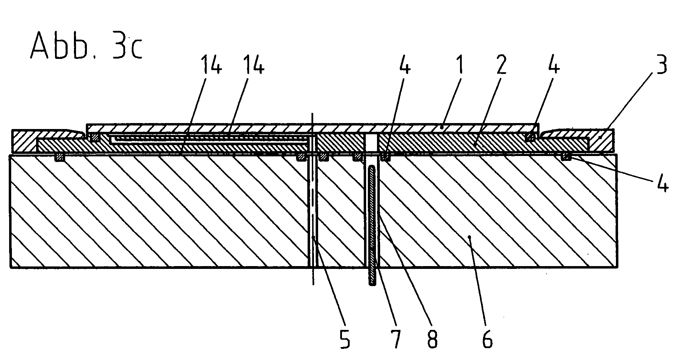

Die auf der dem Wafer abgewandten Seite des mobilen elektrostatischen Halters angebrachten Dichtungen entfallen ggf. wenn eine oder mehrere Dichtungen in der Aufnahme(-vorrichtung) des mobilen elektrostatischen Halters eingebracht sind (Abbildung 3c).

Durch Polieren, Läppen, Schleifen, Feinstdrehen oder Fräsen der dichtenden Oberflächen des mobilen elektrostatischen Halters und / oder der Aufnahme(-vorrichtung) kann die Gasdichtheit weiter verbessert werden.

Gegebenenfalls kann hierdurch auch örtlich, stellenweise oder insgesamt entsprechend der jeweiligen Druck- und Umgebungsverhältnisse auf Dichtungen verzichtet werden.

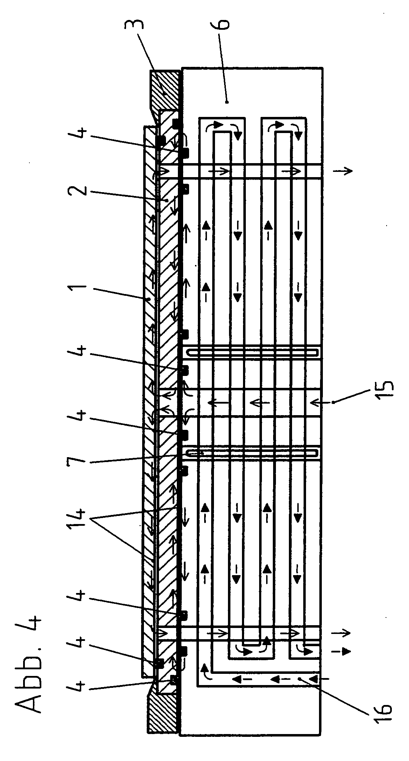

Eine weiter verbesserte Ausführungsform zeigt die Abbildung 4. Hierbei wird das Kühlgas (bevorzugt Helium) durch z. B. die oftmals mit deionisiertem Wasser oder einem Glykolgemisch gekühlte Aufnahme(vorrichtung) des elektrostatischen Halters in einen mit dem vorgenannten Halter gebildeten Zwischenraum, durch z. B. eine oder mehrere ringförmige Gasbohrungen eingeleitet (Abbildung 4). Das Helium kühlt zunächst die dem Wafer abgewandte Rückseite des mobilen elektrostatischen Halters. Anschließend wird das Kühlgas, z. B. über eine bevorzugt mittige oder mehrere Bohrungen in den Zwischenraum zwischen dem Wafer und dem mobilen elektrostatischen Halter (ein-) geleitet.

Hierdurch wird die Rückseite des Wafers sehr effektiv gekühlt.

Durch Gaskanäle (Abbildung 3a) auf der Oberfläche des mobilen elektrostatischen Halters oder / und der Aufnahme(-vorrichtung) kann die Effektivität der Kühlung weiter erhöht werden.

Am äußeren Rand des Wafers strömt falls nötig durch eine Absaugvorrichtung das Kühlgas zurück (Abbildung 4). Dieses kann somit zurückgewonnen werden und ggf. nach einer vorherigen Kühlung weiter verwendet werden. Aufgrund der zusätzlich verwendeten Dichtungen kann das Kühlgas nicht in den umgebenden Prozessraum strömen und die z. B. beim Plasmaätzen, Kathodenzerstäuben (PVD, Sputtern) nötigen Prozessparameter negativ beeinflussen.

Um eine effektive Kühlung der Wafer vorzugsweise mittels Gasen zu erreichen, ist eine möglichst große Kühloberfläche nötig. Beispielsweise bietet sich hierzu eine entsprechende Strukturierung der dem Wafer abund / oder zugewandten Seite des mobilen elektrostatischen Substrathalters sowie der Oberfläche der stationären Aufnahme(vorrichtung) an. Die Strukturierung kann beispielsweise durch Schleifen, Sägen, chemisches Ätzen, Laserschneiden (gleichmäßig strukturierte Oberfläche, sogn. definierte Strukturierung) erfolgen oder z.B. durch Sandstrahlen in Kombination mit den vorgenannten Verfahren erzeugt werden (ungleichmäßig strukturierte Oberfläche, sogn. undefinierte Strukturierung).

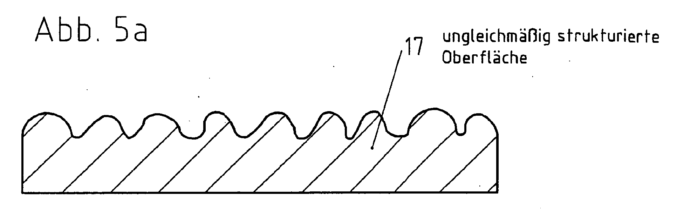

Bevorzugte Strukturierungen weisen ein gleichmäßiges Gittermuster auf (Abbildung 5a-5c). Durch zusätzliches Polieren und / oder Läppen, mechanisches Bearbeiten (z. B. Schleifen, Feinstdrehen, Fräsen) werden die so erzeugten Oberflächen überarbeitet. Hierdurch können gute Ebenheiten und Planparallelitäten der strukturierten Oberflächen hergestellt werden.

### Beschreibung der Zeichnungen

Die Abbildung 1 a beschreibt einen Schnitt durch eine komplette elektrostatische Haltevorrichtung beispielsweise für das Plasmaätzen gemäß dieser Erfindung; dabei ist (1) das Substrat (Wafer), (2) der mobile elektrostatische Halter, (3) der Klemmring mit dem der mobile elektrostatische Halter (2) fixiert ist.

(4) ist (sind) umlaufende Dichtung(en) im mobilen elektrostatischen Halter (2), um die seitliche Abströmung der Gase für die Gaskühlung des Substrates (Wafer) (1) zu verhindern.

Weitere Dichtungen (4) um die Bohrung(en) für die Abhebe bzw. Kontaktstifte (7) für den mobilen elektrostatischen Halter (2) reduzieren zusätzlich die Leckströme des Kühlgases. (5) ist die Bohrung für die Gaskühlung (hier: beispielsweise zentrisch ausgeführt). Die stationäre Aufnahme(-vorrichtung) (6) mit ggf. vorhandenen Kühl- bzw. Heizeinrichtungen, Durchführungen für Kühlgase, Abhebe- und geeignete Kontaktstifte (7) zum elektrischen Laden und / oder Entladen und Sensoren nimmt den mobilen elektrostatischen Halter (2) mit dem Substrat (Wafer) (1) auf. Durch die Abhebe- und Kontaktstifte (7) wird der mobile elektrostatische Halter (2), welcher das Substrat (Wafer) (1) festhält, von der stationären Aufnahme(-vorrichtung) (6) abgehoben bzw. auf dieser abgesetzt oder / und elektrisch geladen bzw. entladen.

Abbildung 1b beschreibt, ebenso wie Abbildung 1 a, einen Schnitt durch eine komplette elektrostatische Haltevorrichtung, beispielsweise für das Plasmaätzen gemäß dieser Erfindung, jedoch ist dieser Schnitt im Vergleich zum Schnitt in Abbildung 1a um 90° gedreht. Die Beschreibung ist hierbei mit der zur Abbildung 1a weitestgehend identisch, lediglich werden hier die gezeigten zusätzlichen Abhebe- bzw. Kontaktstifte (7) nur für das Abheben (Absenken) bzw. für das elektrische Kontaktieren (vor allem Entladen) des Substrates (Wafer) (1) verwendet.

Die Abbildung 2a zeigt in der Draufsicht einen Vorschlag gemäß der Erfindung für einen mobilen elektrostatischen Halter (2), welcher sich beispielsweise zum Schleifen und Polieren eignet. Zur besseren Verdeutlichung ist hier die Darstellung ohne Substrat (Wafer). Neben Bohrungen für Abhebe- und Kontaktstifte (8) verfügt der mobile elektrostatische Halter (2) über eine ringförmige Perforation (9) sowie über eine Reihe von zusätzlichen Bohrungen (10), um das mittels der Vakuumaufnahme (11) (vgl. Abbildung 2b) erzeugte Vakuum neben der elektrostatischen Haltekraft zum Fixieren und Halten des Substrates (Wafer) (1) verwenden zu können. Zudem zeigt Abbildung 2a die umlaufende Dichtung (4).

Abbildung 2b beschreibt einen Schnitt durch Abbildung 2a. Die Darstellung ist hier, zur besseren Verdeutlichung, ohne Abhebe- bzw. Kontaktstifte. Die Vakuumaufnahme (11), aus einem porösen z. B. keramischen Werkstoff gefertigt, hält mittels Vakuum den mobilen elektrostatischen Halter (2), der hält wiederum das Substrat (Wafer) (1) elektrostatisch und durch das erzeugte Vakuum. Zudem zeigt Abbildung 2b umlaufende Dichtungen (4), die einerseits einen für das Vakuum schädlichen Leckstrom möglichst klein halten und andererseits das Eindringen von Schleif- und Poliermitteln sowie ggf. vorhandener Flüssigkeiten (z. B. Schleifemulsionen) verhindern. Außerdem zeigt die Abbildung 2b auch die beispielhafte ringförmige Perforation (9) sowie die für den zusätzlichen Vakuumhalt notwendigen Bohrungen (10) im mobilen elektrostatischen Halter (2).

Die Abbildungen 3a-3c beschreiben jeweils in der Draufsicht (3a) und im Schnitt (3b, 3c) verschiedene Arten den mobilen elektrostatischen Halter (2), beispielsweise für das Plasmaätzen abzudichten, um möglichst geringe Leckströme zu erzielen.

Abbildung 3a zeigt in der Draufsicht die strukturierte Oberfläche zur Gasverteilung (13) mittels Gaskanälen des mobilen elektrostatischen Halters (2). Die Darstellung ist hier, zur besseren Verdeutlichung, ohne Substrat (Wafer) (1).

Der mobile elektrostatische Halter (2) wird über den Klemmring (3) fixiert. Zudem zeigt die Abbildung (eine) zentrische und radiale Bohrungen zur Kühlgasverteilung (12) sowie Dichtungen (4) und die Bohrungen für die Abhebe- bzw. Kontaktstifte (8).

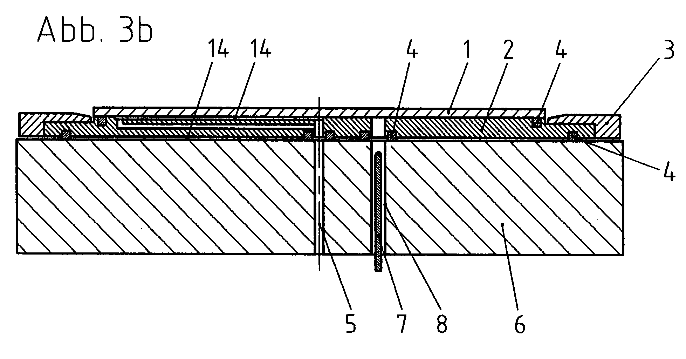

Abbildung 3b beschreibt den Schnitt durch Abbildung 3a. Hierbei sind in den mobilen elektrostatischen Halter (2) die Dichtungen (4) eingelassen. Hierdurch werden einerseits die Rückseite des Substrates.(Wafer) (1) als auch die dem Substrat (Wafer) (1) abgewandte Seite des mobilen elektrostatischen Halters (2) und die einzelnen Bohrungen für die Abhebe- bzw. Kontaktstifte (7), (8), abgedichtet. Der Klemmring (3) fixiert den mobilen elektrostatischen Halter (2). Die Bohrung für die Gaskühlung (5) setzt sich in der stationären Aufnahme(-vorrichtung) (6) fort. Durch die verwendeten Dichtungen (4) entstehen zwischen dem Substrat (Wafer) (1) und dem mobilen elektrostatischen Halter (2) als auch zwischen der stationären Aufnahme(-vorrichtung) (6) abgedichtete, hoch wirksame Zwischenräume (14) zur Kühlung des Substrates (Wafer) (1).

Abbildung 3c zeigt einen zusätzlichen Schnitt durch Abbildung 3a mit einem weiteren Vorschlag gemäß der Erfindung. Die Beschreibung ist hierbei mit der zur Abbildung 3b weitestgehend identisch; abweichend sind lediglich hierbei die Dichtungen (4), die hier auch in die stationäre Aufnahme(-vorrichtung) (6) des mobilen elektrostatischen Halters (2) eingelassen sind.

Die Abbildung 4 zeigt im Schnitt einen weiteren Teil der Erfindung. Der mobile elektrostatische Halter (2) wird durch einen Klemmring (3) auf der Aufnahme(-vorrichtung) (6) gehalten. Der mobile elektrostatische Halter (2) fixiert das Substrat (Wafer) (1). Durch die in den mobilen elektrostatischen Halter (2) und in die stationäre Aufnahme(-vorrichtung) (6) eingelassenen Dichtungen (4) bzw. Dichtflächen entstehen wiederum die zur Gaskühlung benötigten Zwischenräume (14). Durch den gekennzeichneten Kühlgasstrom (15), der in den Zwischenräumen (14) verläuft und der Flüssigkeitskühlung (16) in der stationären Aufnahme(vorrichtung) (6) wird eine sehr effiziente Kühlung des Substrates (Wafer) (1) erreicht. Durch einen geschlossenen Kreislauf des Kühlgases entsprechend dem dargestellten Kühlgasstrom (15) kann das Kühlgas wiederverwendet und falls notwendig temperiert (abgekühlt bzw. erwärmt) werden.

Abbildung 5a-5c zeigt einen Vorschlag gemäß einem Teil der Erfindung, um die Kühlwirkung des Kühlgases durch das Erzeugen einer möglichst großen Kühloberfläche auf einer oder der beiden Seiten (dem Substrat (Wafer) (1) zu- und abgewandte Seite) des mobilen elektrostatischen Halters (2) oder / und der stationären Aufnahme(-vorrichtung) (6) zu verbessern.

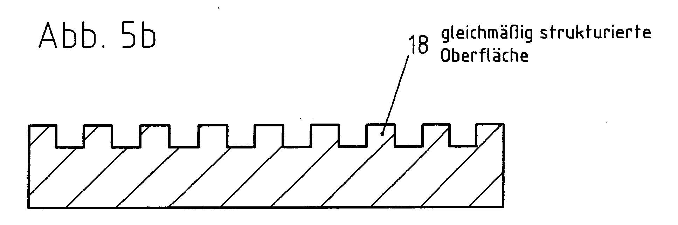

Abbildung 5a zeigt beispielhaft eine durch Sandstrahlen erzeugte ungleichmäßig (undefiniert) strukturierte Oberfläche (17). Diese hat im Vergleich zu einer gleichmäßig (definiert) strukturierten Oberfläche (18) gemäß Abbildung 5b den Vorteil einer meist größeren spezifischen Oberfläche und ist in der Herstellung auch wirtschaftlich günstiger.

Die in Abbildung 5b dargestellte gleichmäßig (definierte) strukturierte Oberfläche (18), welche beispielsweise mit Hilfe reproduzierbarer mechanischer Verfahren (z. B. Fräsen, Sägen, Schleifen) und Strahlverfahren mittels Laser-, Elektronenstrahl oder chemischer Verfahren (z. B. Naß- oder Trockenätzen (Plasmaätzen)) hergestellt werden kann, ermöglicht jedoch gegenüber den behandelten Oberflächen entsprechend Abbildung 5a wesentlich homogenere Kühleigenschaften.

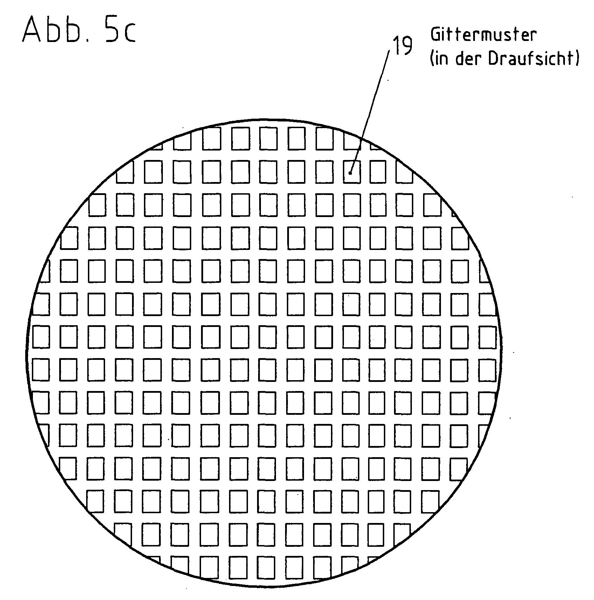

Abbildung 5c zeigt in der Draufsicht das angestrebte Gittermuster (19) der durch das Strukturieren erzeugten Oberflächen gemäß Abbildung 5a und 5b. Durch ein dem Strukturieren nachfolgendes Überschleifen, Läppen, Polieren, Fräsen oder Fein(st)drehen der strukturierten Oberflächen (17), (18) wird ein Gittermuster (19) gemäß Abbildung 5c der behandelten Oberfläche und eine gute Ebenheit und Planparallellität des mobilen elektrostatischen Halters (2) und der stationären Aufnahme(-vorrichtung) (6) des mobilen elektrostatischen Halters (2) erreicht.

## Patentansprüche

1. Mobiler, transportabler elektrostatischer Substrathalter, **dadurch gekennzeichnet, dass** der Durchmesser und / oder die Kantenlängen mit dem des zu transportierenden Substrats (z. B. Wafer) mit einer Genauigkeit, örtlich, stellenweise oder insgesamt, von kleiner 0,1 mm übereinstimmen.

2. Mobiler, transportabler elektrostatischer Substrathalter, **dadurch gekennzeichnet, dass** der Durchmesser und / oder die Kantenlängen um 0,1 bis 30 mm, örtlich, stellenweise oder insgesamt, kleiner als das zu transportierende Substrat (z. B. Wafer) sind.

3. Mobiler, transportabler elektrostatischer Substrathalter, **dadurch gekennzeichnet, dass** der Durchmesser und / oder die Kantenlängen um 0,1 bis zu 150 mm, örtlich, stellenweise oder insgesamt, größer als das zu transportierende Substrat (z. B. Wafer) sind.

4. Mobiler, transportabler elektrostatischer Substrathalter, nach einem oder mehreren der Ansprüche 1 bis 3, **dadurch gekennzeichnet, dass** der nicht durch das zu transportierende Substrat (z.B. Wafer) überdeckte Bereich, örtlich, stellenweise oder insgesamt, um bis zu 30 mm dicker oder bis zu 10 mm dünner als der überdeckte Bereich sein kann.

5. Mobiler, transportabler elektrostatischer Substrathalter, nach einem oder mehreren der Ansprüche 1 bis 4, **dadurch gekennzeichnet, dass** dieser einfach oder mehrfach gelocht und / oder perforiert ist, um beispielsweise die auf das Substrat einwirkende Haltekraft des mobilen elektrostatischen Substrathalters durch das gleichzeitige Nutzen als Vakuumhalter zu verstärken.

6. Mobiler, transportabler elektrostatischer Substrathalter, nach einem oder mehreren der Ansprüche 1 bis 5, **dadurch gekennzeichnet, dass** im Halter und / oder in der Aufnahme(-vorrichtung) für den Halter eine oder mehrere Bohrungen und / oder Perforationen zur Gasdurchführung zum Kühlen des Substrats und / oder für Abhebeund / oder Kontaktstifte und / oder Sensoren vorhanden sind.

7. Mobiler, transportabler elektrostatischer Substrathalter, nach einem oder mehreren der Ansprüche 1 bis 6, **dadurch gekennzeichnet, dass** der Halter mit Kontaktstiften in oder außerhalb der Fertigungsmaschine und / oder das Substrat (z. B. Wafer) elektrisch aufgeladen und / oder elektrisch entladen werden kann.

8. Mobiler, transportabler elektrostatischer Substrathalter, nach einem oder mehreren der Ansprüche 1 bis 7, **dadurch gekennzeichnet, dass** der Halter mit Abhebestiften und / oder das Substrat (z. B. Wafer) bewegt werden kann.

9. Mobiler, transportabler elektrostatischer Substrathalter, nach einem oder mehreren der Ansprüche 1 bis 8, **dadurch gekennzeichnet, dass** auf einer dem Substrat (z. B. Wafer) gegenüberliegenden Seite des Halters und / oder beidseitig und / oder in der Oberfläche der Aufnahme(-vorrichtung) ein oder mehrere Kanäle eingebracht sind, die mit einer oder mehreren Bohrungen (Perforationen) zur Gasdurchführung verbunden sind und durch die ein Kühlgasstrom geleitet werden kann.

10. Mobiler, transportabler elektrostatischer Substrathalter, nach einem oder mehreren der Ansprüche 1 bis 9, **dadurch gekennzeichnet, dass** der Halter mit einer oder mehreren Dichtflächen und / oder Dichtungen (Dichtelementen) auf der dem Substrat (z. B. Wafer) gegenüberliegenden Rück- und / oder Vorderseite ausgestattet ist.

11. Mobiler, transportabler elektrostatischer Substrathalter, nach einem oder mehreren der Ansprüche 1 bis 10, **dadurch gekennzeichnet, dass** der Halter mit Dichtungen bestehend aus Polymeren, z.B. Silikonen, Fluorkunststoffen, Metallen (z. B. Nickel) und / oder Metallegierungen (z. B. Nickelchromlegierungen) massiv oder in Form von Beschichtungen, örtlich oder an mehreren Stellen ausgestattet ist.

12. Mobiler, transportabler elektrostatischer Substrathalter, nach einem oder mehreren der Ansprüche 1 bis 11, **dadurch gekennzeichnet, dass** zwischen dem Substrat (z. B. Wafer) und dem Halter und / oder zwischen der Aufnahme(-vorrichtung) des elektrostatischen Halters und dem elektrostatischen Halter ein oder mehrere zum Kühlen mit Kühlgas geeignete Zwischenräume bestehen.

13. Mobiler, transportabler elektrostatischer Substrathalter, nach einem oder mehreren der Ansprüche 1 bis 12, **dadurch gekennzeichnet, dass** das Kühlgas in einen Kreislauf geführt und wiederverwendet werden kann.

14. Mobiler, transportabler elektrostatischer Substrathalter, nach einem oder mehreren der Ansprüche 1 bis 13, **dadurch gekennzeichnet, dass** in der Aufnahme(-vorrichtung) für den Halter eine oder mehrere Dichtflächen und / oder Dichtungen (Dichtelemente) eingearbeitet sind.

15. Mobiler, transportabler elektrostatischer Substrathalter, nach einem oder mehreren der Ansprüche 1 bis 14, **dadurch gekennzeichnet, dass** die dem Substrat (z. B. Wafer) gegenüberliegende Vorder- und /oder Rückseite des Halters und / oder dessen Aufnahme(-vorrichtung) mittels Sägen, Fräsen, Drehen, Schleifen und / oder Schneiden, z. B. mittels Laser und / oder Elektronenstrahl, naßchemisches Ätzen, Plasmaätzen, Sandstrahlen oder durch ähnliche Verfahren vorzugsweise in Gitterform strukturiert ist, um eine möglichst große Kühloberfläche für das Kühlgas zu erzielen.

16. Mobiler, transportabler elektrostatischer Substrathalter, nach einem oder mehreren der Ansprüche 1 bis 15, **dadurch gekennzeichnet, dass** die dem Substrat (z. B. Wafer) gegenüberliegende Vorder- und /oder Rückseite des Halters und / oder der Aufnahme(-vorrichtung) durch Schleifen und / oder Läppen und / oder Polieren oder Fräsen oder Drehen bearbeitet wird, um eine möglichst gute Ebenheit und Planparallelität zu erzeugen.

17. Mobiler, transportabler elektrostatischer Substrathalter, nach einem oder mehreren der Ansprüche 1 bis 16, **dadurch gekennzeichnet, dass** in die dem Substrat (z. B. Wafer) zugewandten Seite und / oder abgewandte Seite des Halters örtlich, stellenweise oder insgesamt ein oder mehrere magnetische und / oder nichtmagnetische Metalle, Metalllegierungen und / oder Halbmetalle massiv eingearbeitet und /oder die vorgenannten Seiten des Halters örtlich, stellenweise oder insgesamt damit beschichtet sind.

18. Mobiler, transportabler elektrostatischer Substrathalter, nach einem oder mehreren der Ansprüche 1 bis 17, **dadurch gekennzeichnet, dass** auf der dem Substrat (z. B. Wafer) zugewandten Seite und /oder abgewandten Seite des Halters eine oder mehrere unipolare oder / und mehrpolare Elektroden vorhanden sind.

19. Mobiler, transportabler elektrostatischer Substrathalter, nach einem oder mehreren der Ansprüche 1 bis 18, **dadurch gekennzeichnet, dass** in der Aufnahme(-vorrichtung) für den Halter ein oder mehrere Magnete eingearbeitet sind.

20. Mobiler, transportabler elektrostatischer Substrathalter, nach einem oder mehreren der Ansprüche 1 bis 19, **dadurch gekennzeichnet, dass** der elektrostatische Halter mittels der Glas-Multilayertechnik und / oder der Keramik-Multilayertechnik und / oder der Kunststoff-Multilayertechnik hergestellt wird.

21. Mobiler, transportabler elektrostatischer Substrathalter, nach einem oder mehreren der Ansprüche 1 bis 20, **dadurch gekennzeichnet, dass** der elektrostatische Halter aus Keramiken, Gläsern, fotostrukturierbarem Glas, Glaskeramiken, Halbleiterwerkstoffen und /oder Kunststoffen in Kombination mit Metallen und Metallegierungen bestehen kann.

22. Mobiler, transportabler elektrostatischer Substrathalter, nach einem oder mehreren der Ansprüche 1 bis 21, **dadurch gekennzeichnet, dass** durch Feinstbearbeiten, wie Schleifen, Polieren, Läppen, Fräsen, Drehen die Dichtflächen auf der dem Substrat (z. B. Wafer) zu - und / oder abgewandten Seite des Halters und / oder der Aufnahme(-vorrichtung) des elektrostatischen Halters zum Erreichen einer hohen Gasdichtheit bearbeitet sind.

23. Mobiler, transportabler elektrostatischer Substrathalter, nach einem oder mehreren der Ansprüche 1 bis 22, **dadurch gekennzeichnet, dass** dieser stetig oder nicht stetig elektrisch versorgt, elektrisch geladen und / oder entladen werden kann.
